# EUROPEAN PATENT APPLICATION

(11) **EP 4 819 141 A1**
(43) Date of publication of application: **07.10.2026**
(21) Application number: 25168400.7
(22) Date of filing: 03.04.2025
(51) Int. Cl.: G11C 11/54, G06N 3/065, G11C 11/22, G11C 11/56, G11C 16/04

(54) **MEMORY DEVICE FOR IN-MEMORY COMPUTING, PROGRAMMABLE MEMORY ARRAY AND METHOD FOR OPERATING THE MEMORY DEVICE**

(71) Applicant: Semron GmbH, 01067 Dresden (DE)
(72) Inventor: Demasius, Kai-Uwe, 01324 Dresden (DE)
(74) Representative: Lanchava, Bakuri

(57) **Abstract**

A memory device (1) for in-memory computing (1) is provided. The memory device (1) comprises a memory component (10) with at least one measurable property indicative of a least one value stored in the memory device, and a plurality of electrodes (30) for electrically contacting the memory component, characterized in that the memory component (10) has a non-linear characteristic defining a dependence of the at least one measurable property on at least one input parameter, wherein the memory component (10) is configured such that the non-linear characteristic comprises a number of plateaus, wherein for at least one of the plurality of plateaus the measurable property is essentially invariant with respect to a variation of the at least one input parameter. Further a programmable array and a method (100) for operating the memory device (1) is provided.

## Description

The present disclosure generally relates to microelectronic devices. More particularly, the present disclosure relates to a memory device, a programmable memory array and a method for operating the memory device.

There are memory devices for computers known. There are further memory devices for performing analog calculations or analog in-memory calculations known. Such memory devices can substantially speed up the data processing, because at least some of the computer operations can be performed directly in the memory device, thus reducing the load on a processor unit and freeing up processing capacities. Furthermore, the in-memory computing can also help reduce power consumption and open the possibility of monolithic 3D computer, which is only possible with memories so far.

Especially in connection with the latest developments in the field of artificial intelligence (Al) and artificial neural networks, such as transformer models, ever more powerful and faster computers are required. Memory devices with in-memory calculation capabilities that are specially designed for Al-typical operations, such as tensor multiplication, could help to meet these growing requirements.

One of the key problems of analog in-memory computing is precision. This is especially true for large Al models requiring device arrays with a big number of devices for carrying out extensive vector-matrix multiplications. In such device arrays, in particular, due to device-to-device variations and signal noise, even relatively small deviations can be magnified or summed up to lead to inaccuracies in computational results.

Accordingly, one of the objectives of the present disclosure is to provide a memory device and a method of operating the memory device that can help to increase the precision of in-memory calculations.

To solve this problem, according to a first aspect, a memory device for in-memory computing is provided. The memory device comprises a memory component with at least one measurable electrical property indicative of a least one value stored in the memory device. In particular, the memory component may comprise a memory medium capable of storing the at least one value of the storage variable.

The memory device further comprises a plurality of electrodes for electrically contacting the memory component. In particular, the plurality of electrodes may be configured to receive a writing signal for writing data, e.g. by changing stored values, in the memory device and to read out the data or values stored in the memory device. The plurality of electrodes may comprise two or more electrodes for electrically contacting the memory component, depending on the embodiment.

The plurality of electrodes may comprise a word-line (WL) contact and a bit-line (BL) contact for operating the memory device as a memory cell within an array of similar memory cells, in particular, in a matrix structure for carrying out certain in-memory computations. The array of the memory cells may e.g. comprise one or more accumulators or adders for adding the values of different bits with their respective weights. Thereby, the weights of the bits may be stored and/or modified as the at least one storage variable in the respective memory devices serving as memory cells of the array. In some embodiments, the plurality of electrodes also comprise at least one control electrode, in particular, for applying at least one bias voltage on the memory component.

The memory component has a non-linear characteristic defining a dependence of the at least one measurable property on at least one input parameter, wherein the memory component is configured such that the non-linear characteristic comprises a number of plateaus, wherein for at least one of the plurality of plateaus, in particular, for each of the plateaus, the at least one measurable property is essentially invariant with respect to a variation of the at least one input parameter. Depending on the embodiment, the plurality of plateaus may comprise two or more, in particular four or more plateaus. In some embodiments, the non-linear characteristic may comprise 8, 16 or more plateaus.

Depending on the embodiment, the at least one input (programming or writing parameter) may comprise at least one of the following: programming time, programming voltage, programming current, pulse frequency, duration and/or shape.

Based on the dependence between the at least one property of the memory component and the at least one input parameter, the at least one input parameter can be used for writing or programming the memory device, in particular, by changing the at least on property. Thus, the memory device can be used as a rewritable memory cell of a rewritable memory, e.g. RAM (random access memory) for computing.

Thereby, due to the invariance of the at least one property of the memory component with respect to the at least one input parameter, any fluctuation or drift of the at least one input parameter, within a plateau range of the non-linear characteristic has essentially no effect on the at least one property of the memory component.

The non-linear function may, in particular, comprise a plurality, e.g. two or more, plateaus or stairs at predefined positions or value ranges of the at least one input parameter. By choosing the value of the at least one input parameter, i.e. writing parameter, in one of the predefined ranges, a robust and precise writing at different values of the writing parameters can be achieved. Respectively, an accumulator based on such memory devices can be programmed accordingly by precisely defining the weights of each separate cell or bit. This makes the memory device particularly robust against input deviations, such as thermal fluctuations and noise during the writing process.

The at least one measurable property may comprise at least one electrical property, in particular, resistance, conductance and/or capacitance, of the memory component. In particular, the memory component may be a resistive and/or capacitive memory component, with variable resistance, conductance and/or capacitance, accordingly. These electrical characteristics can be easily measured to read the data stored in the memory device.

In case of capacitance, the memory device can be also referred to as CapRAM, since the capacitance of the memory component is used as the measurable property indicative of the at least one value stored in the memory device. Similarly, in case of resistance, the memory device can be referred to as ReRAM, since the resistance of the memory component is used as the measurable property indicative of the at least one value stored in the memory device.

In some embodiments, the non-linear characteristic is at least partially a substantially monotonic staircase function, in particular with essentially flat steps. The monotonic staircase function may comprise, in particular, one or more monotonically increasing and/or monotonically decreasing sections, such that the values stored in the memory device can be modified by accordingly incrementing or decrementing the at least one input parameter, i.e. writing parameter.

The staircase function may comprise essentially non-flat staircase steps for compensating manufacturing-related deviations (e.g. geometrical variations), in particular for fine adjustment of the device parameters. Although, in most cases, the staircase needs to be very flat, e.g. at correspondingly programmed capacitance values, a non-flat staircase can also be used for a fine adjustment of the memory component properties. In particular, a 1% deviation due to layer thickness or geometric variations can be changed to 0.1% by a non-flatness of 1% in the plateau with 10 programming states.

In some embodiments, the at least one step of the staircase function may comprise a sub-staircase with a plurality of smaller steps (sub steps). For instance, for compensation of a 1 % deviation, 10 levels with 0.1 % increment can be used. Such sub-staircase can combine the advantages of the staircase function with the ability to compensate manufacturing-related deviations.

The plurality of electrodes may comprise a word line (WL) contact and a bit line (BL) contact for integrating the memory device into an array of, in particular, essentially similar memory devices as a multi-level memory cell, the at least one measurable property serving as a multi-level weight parameter of the cell. Due to the non-linear characteristic of the memory component, the array can be used for carrying out weighted in-memory operations with a high precision and low standard deviation.

In some embodiments, the deviation (3σ) of the weight parameter is at most 0.1 %, in particular, at most 0.05 % or at most 0.01 %. With such weight parameters, even larger accumulators, e.g. with 4096 word lines or more, can be operated for high precision in-memory operations. Depending on the implementation, the deviation of the weight parameter may differ from the above values. In some embodiments, the deviation is not exceeding 5 %, in particular, not exceeding 2 % or 1 %.

In some embodiments, at least some of the number of plateaus of the characteristic covers at most 6 %, in particular at most 3 % or at most 1 %, of the total range of the at least one input parameter. In particular, the plateaus may have such widths that the dynamic range of the at least one input parameter or memory window can cover multiple plateaus, defining a multiplicity of preferred sub-ranged for the at least one input parameter. With plateaus covering less than 6 % of the total range, a memory cell with up-to 16 levels and with plateaus covering less than 3 % of the total range, a memory cell with up-to 32 levels can be implemented.

In some embodiments, the at least one input parameter is voltage, wherein the width of at least some of the plateaus is at most 1700 mV, in particular, at most 1500 mV, at most 1000 mV, at most 500 mV, at most 250 mV, at most 125 mV, at most 100 mV, at most 75 mV or at most 50 mV. With such a memory device, a memory cell with 16 or more levels can be implemented. Furthermore, such step width is still larger than thermal fluctuations (typically about 30 meV) such that the writing process cannot be affected by thermal fluctuations. Basically, the step width depends on the memory window or voltage range. For instance, a memory window of typically 3.5 to 4 volts and a plateau width of 218 to 250 mV would result in a 16-step density.

The memory component may comprise a MOS (metal oxide semiconductor) capacitor configured such that a depletion layer expansion stops for a certain voltage range within at least one of the plateaus. By stopping the depletion layer expansion, the size of the depletion region can be kept essentially constant, as long as the voltage remains within the voltage range. Consequently, the capacitance of the MOS capacitor, which can serve as a storage variable, can also be kept essentially constant.

The MOS capacitor may comprise layers doped to varying degrees. In particular, the MOS capacitor may comprise a sequence of highly doped regions and lightly doped regions, in particular, with as many highly doped intermediate layers as necessary for achieving the desired number of stairs in the staircase function. In particular, in the writing process, the depletion region would stop at these highly doped layers or regions until the respective region is fully depleted. Accordingly, the highly doped layers can serve as stopping points or boundaries to get the desired staircase characteristic. In particular, the expansion of the depletion region would advance from region to region, resulting in the staircase characteristic, e.g. C-V curve, of the memory component.

The memory component may comprise thin tunnel oxide layers between highly doped regions and lightly doped regions. The tunnel oxide can help to avoid charge carrier diffusion between the highly doped regions and the lightly doped regions, thus improving the flatness of the plateaus, which can be impaired by the out-diffusion of charge carriers.

In some embodiments, the memory component comprises a plurality of stacked silicon layers with dielectric layers in between, in particular, depletable in a stepwise manner. In particular, the stacked silicon layers may have different doping levels in each layer, different bias voltages and/or different fixed charges, such that the depletion process does not take place simultaneously for all layers but rather one by one in a stepwise manner. The fixed charges may be thereby generated either in a SiO2 interface or by using the interface of two different high-k dielectrics and their polarity properties.

In some embodiments, the memory component is configured as or comprises a quantum capacitance. The quantum capacitance may be, in particular, based on a 2D (two-dimensional) electron gas quantization principle, with an intrinsic staircase behavior, resulting in the staircase characteristic of the memory component.

According to a second aspect, a programmable memory array is provided. The memory array comprises a plurality of memory devices according to the first aspect, wherein the memory devices are arranged and interconnected in the memory array such that the memory devices can be used as memory cells for weighted vector and/or matrix calculations, the at least one measurable property serving as a multi-level weight parameter of each cell.

According to a further aspect, a method for operating a memory device is provided. The memory device may be, in particular, configured according to the first aspect described above. The method may, in particular, comprise, providing at least one memory device comprising a memory component with at least one measurable property indicative of at least one value stored in the memory device, and a plurality of electrodes for electrically contacting the memory component. The memory component has a non-linear characteristic defining a dependence of the at least one measurable property on at least one input parameter, wherein the memory component is configured such that the non-linear characteristic comprises a plurality of plateaus, wherein for at least one of the plurality of plateaus the measurable property is essentially invariant with respect to a variation of the at least one input parameter. The method also comprises providing an external input, in particular, to the plurality of electrodes, with at least one input parameter in the range of at least one of the plurality of plateaus of the non-linear characteristic.

Due to the external input with the input parameter in the plateau range, the at least one property of the memory component can be changed for programming the memory device, whereby the plateaus in the non-linear characteristic ensure that the impact of input deviations on the stored value is reduced.

The method may further comprise providing a readout signal for reading out the at least one value stored in the memory device. The method may also comprise detecting a response of the memory device to the readout signal in order to read out the data stored in the memory device. In particular, the providing the readout signal may comprise providing at least one readout parameter, e.g. readout voltage, in the range of at least one of the plateaus, such that the readout signal does not change at least one measurable property of the memory component. Hence, the method enables a robust and reliable writing and reading of date with a low risk of unintentional rewriting of data during the reading process.

The providing at least one memory device may comprise providing a plurality of memory devices forming a memory array, such that the memory devices can be used as memory cells for weighted vector and/or matrix calculations, the at least one measurable property serving as a multi-level weight parameter of each cell. The method may further comprise performing vector and/or matrix in-memory calculation with the weight parameters stored in the cells of the memory array.

According to another aspect of the present disclosure, a memory device for in-memory computing is provided. The memory device comprises a memory component and a plurality of electrodes for electrically contacting the memory component in order to allow reading at least one value out of and/or writing at least one value to the memory device, wherein the memory component is characterized by a CV or RV hysteresis curve comprising a plurality of plateaus.

In an embodiment according to this aspect, the hysteresis curve represents at least in part a substantially monotonic staircase function. In an embodiment according to this aspect, at least one step of the staircase function comprises a sub-staircase with a plurality of smaller steps.

In an embodiment according to this aspect, at least one input signal applied to the memory component during programming of the memory component is associated to a plateau in the plurality of plateaus. The at least one input signal may be associated to any of the following parameters: programming time, programming voltage, programming current, pulse frequency, pulse duration, pulse shape.

In an embodiment according to this aspect, the staircase function comprises non-flat staircase steps for compensating manufacturing-related deviations, in particular for fine adjustment of the device parameters.

In an embodiment according to this aspect, the plurality of electrodes comprises a word line (WL) contact and a bit line (BL) contact for integrating the memory device into an array of memory devices so as to form a multi-level memory cell associated to a multi-level weight parameter.

Further to this aspect, a method for operating the memory device according to this aspect is provided. The method comprises: providing at least one memory device comprising a memory component and a plurality of electrodes for electrically contacting the memory component in order to allow reading at least one value out of and/or writing at least one value to the memory device, wherein the memory component is characterized by a CV or RV hysteresis curve comprising a plurality of plateaus; and providing an external input signal to the plurality of electrodes, the input signal being associated to at least one of the plurality of plateaus.

Further, a programmable memory array comprising a plurality of memory devices according to this aspect. The memory devices are arranged and interconnected in the memory array such that the memory devices can be used as memory cells for weighted vector and/or matrix calculations, with each cell being associated to a multi-level weight parameter.

The invention will now be explained in more detail with reference to the attached figures. The same reference symbols are used in the figures for identical or similarly acting parts.
- Fig. 1: shows a typical characteristic of a memory component according to some embodiments,
- Fig. 2: shows a typical characteristic of a memory component according to some embodiments,
- Fig. 3: shows a typical characteristic of a memory component according to some embodiments,
- Fig. 4: shows qualitatively a typical characteristic curve with modified step function for illustrating a fine adjustment of the memory component according to some embodiments,
- Fig. 5: shows a schematic cross section through a memory device according to an embodiment,
- Fig. 6: shows a schematic cross section through a memory component according to an embodiment,
- Fig. 7: shows a schematic cross section through a memory component according to another embodiment,
- Fig. 8: shows a schematic cross section through a memory component according to still another embodiment,
- Fig. 9: shows a schematic cross section through a memory component according to a further embodiment,
- Fig. 10: shows a typical density-of-state diagram of a 2D electron gas, which is used for achieving a staircase characteristic of the memory component according to some embodiments, and
- Fig. 11: shows a flow chart of a method for operating a memory device, according to an embodiment.

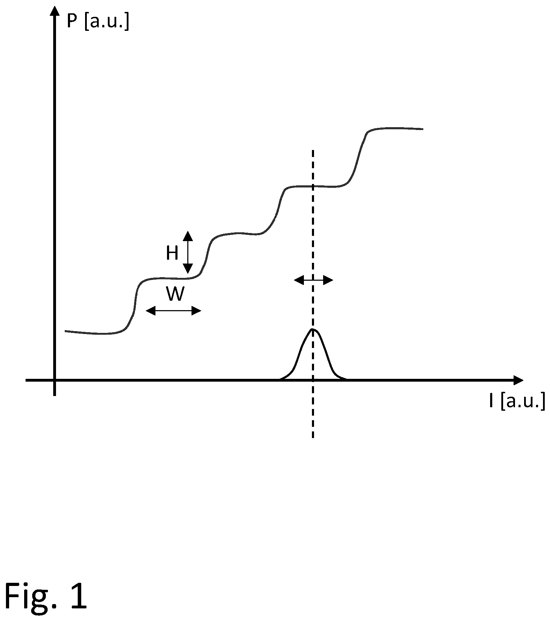

Fig. 1 shows a typical characteristic (programming curve) of a memory component according to some embodiments. In particular, Fig. 1 shows a response curve of the memory component, representing a dependence between at least one input parameter I and at least one measurable property P of the memory component, in arbitrary units.

Depending on the embodiment, the at least one input parameter may comprise e.g. programming time, programming voltage, programming current, pulse frequency, pulse duration and/or shape.

The at least one measurable property P may comprise, in particular, resistance R and/or capacitance C of the memory component.

In the shown embodiment, the characteristic curve corresponds to a typical staircase function and comprises a number of essentially flat steps or plateaus and a number of relatively steep transition regions between the plateaus.

The stairs of the staircase function may be characterized by their respective widths W and heights H.

Due to the staircase shape of the characteristic curve, the property P is essentially invariant with respect to any fluctuation of the input parameter, as long as the input parameter remains within one step.

Fig. 1 also shows an exemplary Gaussian-like distribution of the input parameter I for illustrating the robustness of the writing process with respect to input deviations.

Especially for analog in-memory calculations, the robustness of the writing process against any input fluctuations can play a crucial role.

For instance, in case of a typical accumulator for a vector-vector multiplication with sum up, the accumulator precision needs to be: ${b}_{A} = {log}_{2} \left({2}^{{b}_{I}}-1\right) + {log}_{2} \left({2}^{{b}_{W}}-1\right) + {log}_{2} N$

Where *b_{A}* is the accumulator bit precision, *b_{W}* is the weight bit precision, *b_{I}* is the input bit precision and *N* is the input vector size. Assuming that the weights have some statistical variation σ*_{W}* (in % of total value) then we have in the following max variance after each multiplication: ${σ}_{mult} = {σ}_{W} ⋅ \left({2}^{{b}_{I}}-1\right) ⋅ \left({2}^{{b}_{W}}-1\right)$

For the whole BL with accumulation of N values we get: ${σ}_{tot} = \sqrt{N} ⋅ {σ}_{W} ⋅ \left({2}^{{b}_{I}}-1\right) ⋅ \left({2}^{{b}_{W}}-1\right)$

The maximum value of the whole BL is: ${V}_{BL} = \left({2}^{{b}_{I}}-1\right) ⋅ \left({2}^{{b}_{W}}-1\right) ⋅ N$

Therefore, the maximum bit precision is (assuming a 3σ*ₜₒₜ* variation per Least Significant Bit): ${b}_{A , σ} = \frac{{V}_{BL}}{3 {σ}_{tot}} = \frac{\left({2}^{{b}_{I}}-1\right) ⋅ \left({2}^{{b}_{W}}-1\right) ⋅ N}{3 ⋅ \sqrt{N} ⋅ {σ}_{W} ⋅ \left({2}^{{b}_{I}}-1\right) ⋅ \left({2}^{{b}_{W}}-1\right)} = \frac{\sqrt{N}}{3 ⋅ {σ}_{W}}$

Therefore, the following condition must be fulfilled: ${b}_{A , σ} \geq {b}_{A}$

In order to overcome the precision issue, one can reduce the input bit width and/or the weight bit width. This can be achieved, e.g. by a clever quantization technique, but is usually limited to a minimum 4 bits. Another approach is using the so-called bit slicing and splitting the 4x4 bit multiplication into 1x1 or 2x2 Bit multiplications. However, this would reduce the weight density by a factor of 4 or 2 and the total number of vectors matrix multiplications to be performed is increased by a factor of 16 or 4, resulting in a reduced energy efficiency and performance.

The calculation accuracy can be increased by reducing the sigma variation of the programmed weights σ*_{W}.*

This translates to the following *3*σ*_{W}* variation (1 LSB error in 370 cases): $3 {σ}_{w} = \frac{\sqrt{N}}{{2}^{{b}_{A}}} = \frac{1}{\left({2}^{{b}_{I}}-1\right) ⋅ \left({2}^{{b}_{W}}-1\right) ⋅ \sqrt{N}}$

**Usually,** *3*σ*_{W}* of around 0.1 % or below are necessary in order to achieve the necessary accuracy. This would correspond to an equivalent bit precision of 1000 levels or almost 10 bit. When looking at most resistive or memcapacitive devices these values are far away or can be only achieved by using a lot of error correction cycles (write-read-write etc.), which increases write time by a lot. Also, it cannot be guaranteed that these values will stay constant when temperature changes and the memory cells value drift during retention loss.

Due to the staircase shape of the characteristic curve, as long as the input parameter I remains in the range of the same cell, the response of the memory component, i.e. the measurable property P, remains the same, minimizing the calculation error.

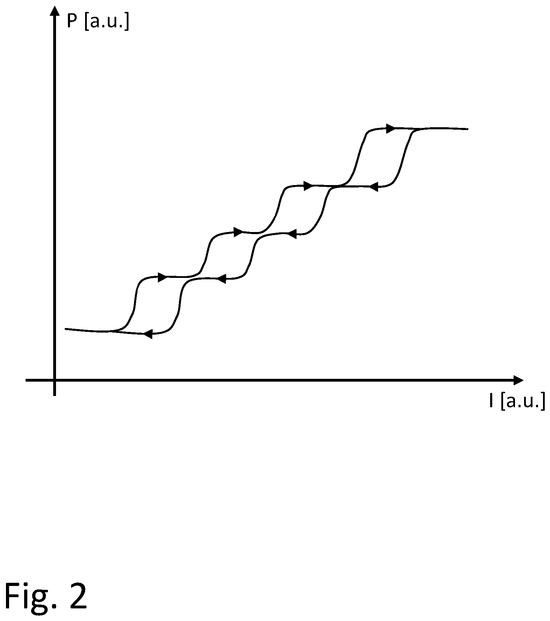

Fig. 2 shows a typical characteristic of a memory component according to some embodiments. In the shown embodiment, the characteristic curve shows a hysteresis effect which may occur in some memory devices. In particular, usually in memory devices the resistance change is connected with a hysteretic shift in R-V or C-V curves, which opens a memory window.

Due to the staircase shape of the curve, the effect of hysteresis can be at least partially compensated.

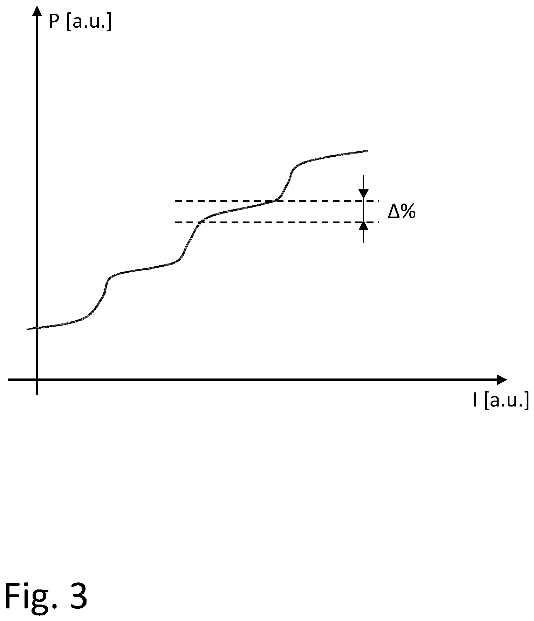

Fig. 3 shows a typical characteristic of a memory component according to some embodiments. In the shown embodiment, tilted with respect to the X axis. Due to the tilt, the property P varies with a certain increment Δ over each step, such that the tilt can be used for a fine adjustment of the memory component of the memory device.

Usually, the staircase needs to be very flat at the programmed capacitance value. But a non-flat staircase can also be used as fine adjustment. E.g. the distances between staircases can vary due to thickness and area variation during fabrication of the device. If one has an area variation of e.g. 1 % but need a capacitance or resistance variation of 0.1 % (3σ_W) then the R-V or C-V curve can vary along the specific staircase by 1 %. This can be implemented either by a smaller sub staircase or linear progression, where 10 levels are necessary for the 1 % / 0.1 % example.

Depending on the embodiment, the increment Δ may amount for substantial percentage of the whole range of the property P, e.g. more than 1 %, in particular, more than 3 %, and can be used to compensate for any non-ideality of the memory component.

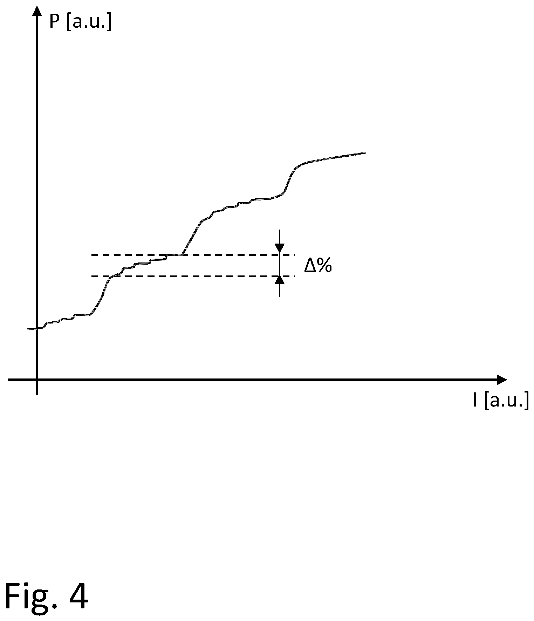

Fig. 4 shows a typical characteristic of a memory component according to some embodiments. The characteristic curve of Fig. 4 essentially corresponds to the characteristic curve shown in Fig. 3, wherein sub-staircases are implemented for fine tuning and/or compensation of non-idealities.

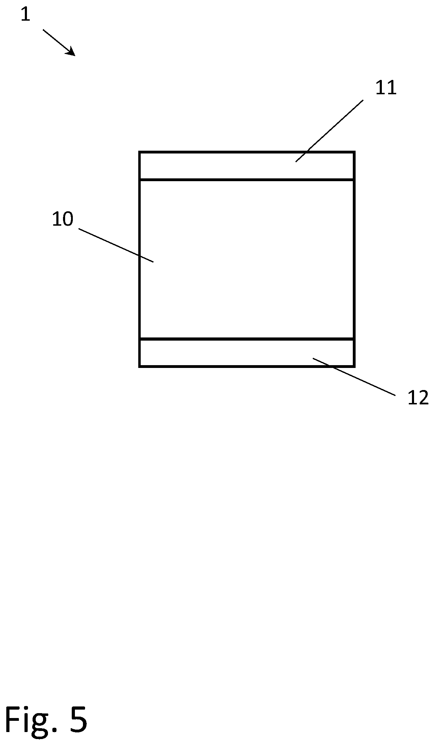

Fig. 5 shows a schematic cross section through a memory device according to an embodiment. In the embodiment of Fig. 5, the memory device comprises a memory component 10 as well as a number of electrodes 11 and 12 for contacting the memory component 10.

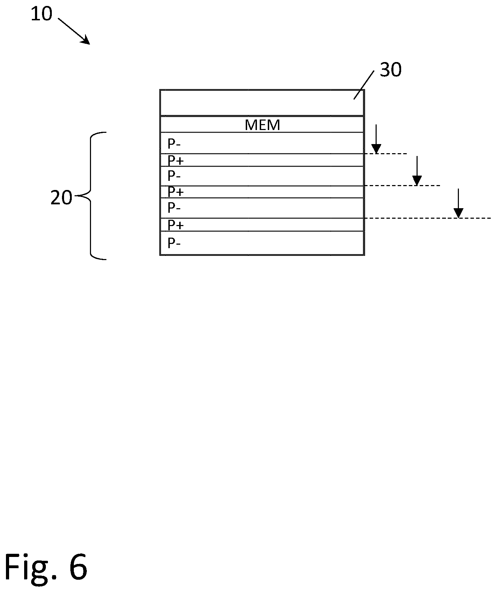

Fig. 6 shows a schematic cross section through a memory component according to an embodiment. In the embodiment of Fig. 6, the memory component 10 is configured as a gate stack, comprising a semiconductor layer 20, a memory layer (MEM) and a gate 30 on top. In some embodiments, the memory layer may be a part of the semiconductor layer 20.

The semiconductor layer 20 comprises a number of successive layers, comprising lightly doped (P-) layers and highly doped (P+) layers. Due to such a layer structure, a depletion process of the semiconductor layer 20 can occur in a cascaded manner. In particular, starting from the top, e.g. due to applying a certain gate voltage as an input parameter, the depletion can advance downwards and can be stopped by the upper most highly doped layer (P+), if the gate voltage is further increased, the depletion front may move further to the next highly doped layer (P+) and so on. The stepwise or cascaded depletion, indicated by the downward arrows on the right side of Fig. 6, results in a staircase characteristic of the memory component, e.g. as shown in Fig. 1.

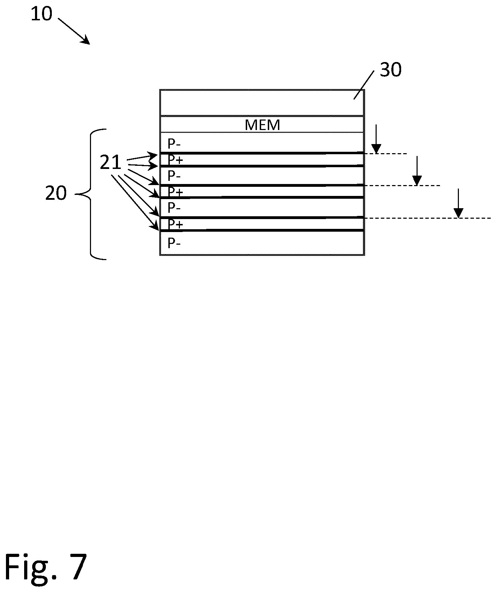

Fig. 7 shows a schematic cross section through a memory component according to another embodiment. The embodiment of Fig. 7 essentially corresponds to the embodiment of Fig. 6, wherein the memory component further comprises a number of tunnel barriers 21 arranged between the lightly doped layers (P-) and highly doped layers (P+).

Due to the tunnel barriers 21, charge carrier diffusion between the lightly doped layers (P-) and highly doped layers (P+) subdued, resulting in steeper transitions between the stairs in the staircase function.

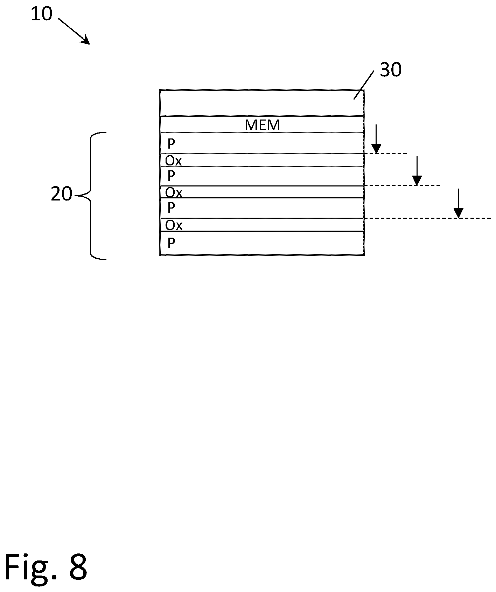

Fig. 8 shows a schematic cross section through a memory component according to still another embodiment. In the embodiment of Fig. 8, the memory component 20 comprises a number of semiconductor layers (P) and a number of dielectric insulator layers (Ox).

This kind of configuration of the memory component 20 can also lead to a stepwise depletion, as indicated by the downward arrow on the right, thereby achieving a desired staircase function, e.g. as shown in Figures 1 to 4.

A desired staircase function can be, in particular, implemented by adjusting the doping levels of each semiconductor layer (P), bias voltages of the layers and/or fixed charges in the dielectric layers (Ox).

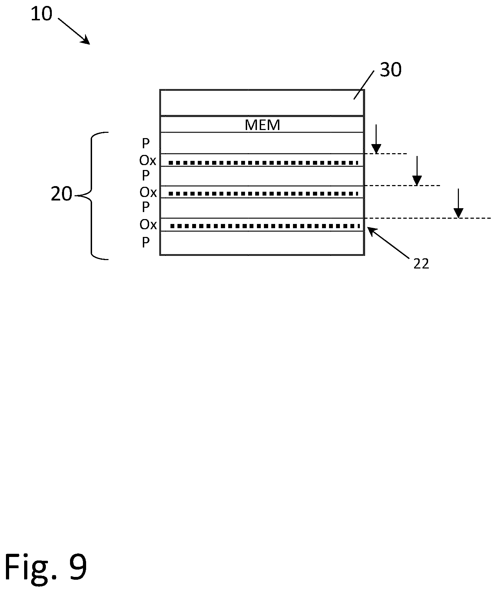

Fig. 9 shows a schematic cross section through a memory component according to a further embodiment. The embodiment of Fig. 9 essentially corresponds to the embodiment of Fig. 8. wherein the dielectric insulator layers (Ox) comprise fixed charges 22 indicated as dotted lines in Fig. 9.

The fixed oxide charges in the dielectric can be generated either in a SiO2-Si interface or by using the interface of two different high-k dielectrics and their polarity properties.

In some embodiments, an oxide semiconductor is used in order to deposit the entire stack by ALD (atomic layer deposition) which allows very small thickness variation. This can be for example InGaZnO or TiO2 or similar oxides.

The memory layer may comprise a multilayer dielectric structure, e.g. ONO (Oxide-Nitride-Oxide. Depending on the embodiment, the memory layer may comprise a charge trap memory and/or ferroelectric memory.

In some embodiments, the memory layer comprises a quantum memory element, e.g. based quantum capacitance. In particular, the quantum mechanical properties of a 2D electron gas and the corresponding quantization of the density of states can be used. Thereby, the capacitance is quantized according to the occupation of electrons within the density of state.

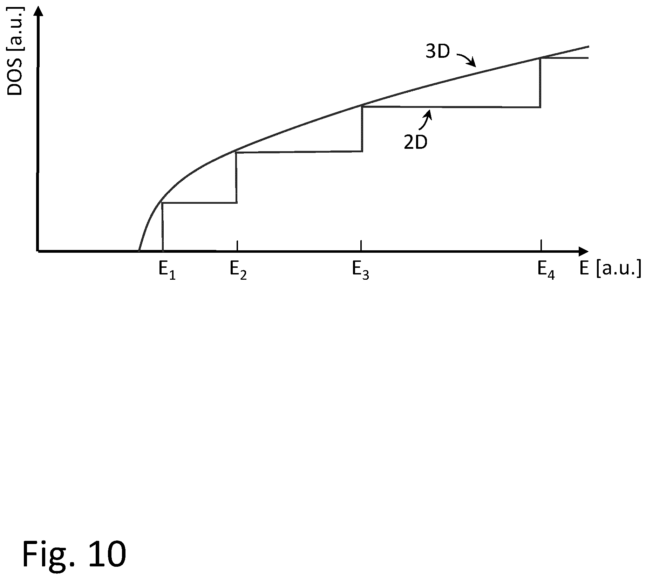

Fig. 10 shows a typical density-of-state diagram of a 2D electron gas, which is used for achieving a staircase characteristic of the memory component according to some embodiments. In particular, Fig. 10 shows the quantization of the density of states (DOS) of a 2D electron gas as a function of energy in arbitrary units.

The advantage of quantum mechanical implementation is that the steepness of the staircase transitions can be increased. In semiconductors, the steepness of the transition between two adjacent stairs is limited by thermal fluctuations, similar to the subthreshold slope limitation at 60mV/Dec, taking place in field effect transistors. The limited steepness leads to a limited number of staircases for a given memory window.

Using the quantum mechanical properties of the 2D electron gas, these limitations on the steepness can be overcome.

In some embodiment, the semiconductor in the MOS capacitor is at least partially replaced by a material with a Mott transition or metal-to-insulator transition, which allows significantly steeper edges at the step transition.

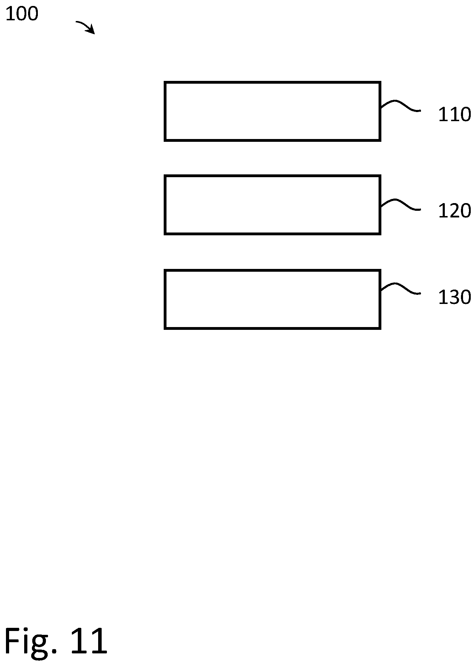

Fig. 11 shows a flow chart of a method for operating a memory device, according to an embodiment. The method 100 may be applied on a memory device according to one of the embodiments described above.

In the embodiment of Fig. 11, in step 110, a memory device, in particular, according to one of the embodiments described above, is provided. The memory device may be, in particular, configured as a memory cell integrated in a memory cell array for carrying out logical in-memory operations.

In step 120, an external input is provided on the number of electrodes of the memory device, with at least one input parameter in the range of at least one of the plateaus of the non-linear characteristic of the memory component.

Providing the input in step 120 may comprise applying a writing voltage on the number of electrodes of the memory device, the writing voltage being in the range of one of the plateaus of the characteristic curve of the memory component. The plateaus in the non-linear characteristic curve ensure thereby that the impact of input deviations on the stored value is reduced.

In the shown embodiment, the method 100 also comprises providing 130 a readout signal for reading out the at least one value stored in the memory device. The method may also comprise detecting a response of the memory device to the readout signal in order to read out the data stored in the memory device. In particular, providing the readout signal in step 130 may comprise providing at least one readout parameter, e.g. readout voltage, in the range of at least one of the plateaus, such that the readout signal does not influence at least one measurable property of the memory component. Hence, the method enables a robust and reliable writing and reading of date with a low risk of unintentional rewriting of data during the reading process.

By means of the memory devices described above, the writing or programming of the memory cell can be performed in one step and the retention of 10 bit accurate weights can in principle be sustained for 10 years over a wide temperature range.

Furthermore, most neural networks are trained on digital hardware, therefore comparability between digital and analog hardware when it comes to precision is key and many in-memory computing approaches suffer from this problem. The memory device and the method described above would enable the customer to implement neural networks being trained on digital hardware directly on the analog hardware without much overhead for retraining the neural network or accuracy loss.

Thereby, as described above, the plateaus in the characteristic curve can not only reduce noise but also compensate for any hysteresis of the characteristic curve, such that it practically does not affect the function of the memory device.

In CV curves for capacitive devices the temperature variation happens in semiconductors usually on the transition between depletion and inversion/accumulation. Once the semiconductor is fully depleted or inverted/accumulated, there will be no (or much reduced) temperature variation on the flat staircase. The drift will not affect the value much because of the flatness on the staircase.

In particular, due to the stabilizing effect of the plateaus in the non-linear characteristic of the memory component, a quasi-digital precision of analog in-memory calculations can be achieved.

Furthermore, the drift- and temperature tolerance of the memory device can be increased, and time-consuming calibrations can be avoided, which would be otherwise necessary, especially for memory devices without such a non-linear dependence between the at least one electrical property and the at least one input parameter.

Moreover, non-linearity or error rate during read-out can be reduced as well, since the at least one measurable property of the memory component, e.g. capacitance, will not change with the applied voltage change, within a plateau region, during a read-out step.

The embodiments described above are merely examples and are not intended to limit the scope, applicability, or configuration of the present disclosure in any way. Rather, the foregoing description provides the skilled person with a blueprint for implementing at least one exemplary embodiment, wherein numerous changes may be made in the function and arrangement of the elements described in an exemplary embodiment without departing from the scope of the appended claims their legal equivalents. Furthermore, several modules or several products can be combined according to the principles described herein in order to obtain additional functions.

### List of reference symbols

- 1: memory device
- 10: memory component
- 11: electrode
- 12: electrode

- 20: semiconductor layer
- 21: tunnel barrier
- 22: fixed charges

- 30: gate

- 100: method
- 110: method step
- 120: method step
- 130: method step

## Claims

1. Memory device (1) for in-memory computing, comprising:
- a memory component (10) with at least one measurable property indicative of at least one value stored in the memory device, and
- a plurality of electrodes (11,12) for electrically contacting the memory component, **characterized in that**
the memory component (10) has a non-linear characteristic defining a dependence of the at least one measurable property on at least one input parameter, wherein the memory component (10) is configured such that the non-linear characteristic comprises a plurality of plateaus, wherein for at least one of the plurality of plateaus the at least one measurable property is essentially invariant with respect to a variation of the at least one input parameter.

2. The memory device according to claim 1, wherein the at least one measurable property comprises at least one electrical property, in particular, resistance, conductance and/or capacitance, of the memory component (10).

3. The memory device according to claim 1 or 2, wherein the non-linear function is at least partially a substantially monotonic staircase function.

4. The memory device according to claim 3, wherein the staircase function comprises essentially non-flat staircase steps for compensating manufacturing-related deviations, in particular for fine adjustment of the device parameters.

5. The memory device according to claim 3 or 4, wherein at least one step of the staircase function comprises a sub-staircase with a plurality of smaller steps.

6. The memory device according to one of the previous claims, wherein the plurality of electrodes comprises a word line (WL) contact and a bit line (BL) contact for integrating the memory device into an array of, in particular essentially similar, memory devices as a multi-level memory cell, the at least one measurable property serving as a multi-level weight parameter of the cell.

7. The memory device according to claim 6, wherein the deviation (3σ) of the weight parameter is at most 0.1 %, in particular, at most 0.05 % or at most 0.01 %.

8. The memory device according to one of the previous claims, wherein at least some of the plurality of plateaus characteristic covers at most 6 %, in particular at most 3 % or at most 1 %, of the total range of the at least one input parameter.

9. The memory device according to one of the previous claims, wherein the at least one input parameter is voltage, and wherein the width of at least some of the plateaus is at most 1500 mV, in particular at most 1000 mV, at most 500 mV, at most 250 mV, at most 125 mV, at most 100 mV or at most 75 mV.

10. The memory device according to one of the previous claims, wherein the memory component (10) comprises a memcapacitive component with a MOS capacitor configured such that a depletion layer expansion stops for a certain voltage range within at least one of the plateaus.

11. The memory device according to claim 10, wherein the MOS capacitor comprises layers doped to varying degrees.

12. The memory device according to claim 11, wherein the memory component (10) comprises thin tunnel oxide layers between highly doped layers and lightly doped layers.

13. The memory device according to one of the previous claims, wherein the memory component (10) comprises a plurality of stacked silicon layers with dielectric in between, in particular depletable in a stepwise manner.

14. Programmable memory array, the programmable memory array comprising a plurality of memory devices according to one of the previous claims, wherein the memory devices (1) are arranged and interconnected in the memory array such that the memory devices can be used as memory cells for weighted vector and/or matrix calculations, the at least one measurable property serving as a multi-level weight parameter of each cell.

15. Method for operating a memory device, comprising:
- providing (110) at least one memory device comprising a memory component with at least one measurable property indicative of at least one value stored in the memory device, and a plurality of electrodes for electrically contacting the memory component, wherein the memory component has a non-linear characteristic defining a dependence of the at least one measurable property on at least one input parameter, wherein the memory component is configured such that the non-linear characteristic comprises a plurality of plateaus, wherein for at least one of the plurality of plateaus the measurable property is essentially invariant with respect to a variation of the at least one input parameter, and
- providing (120) an external input to the plurality of electrodes, with at least one input parameter in the range of at least one of the plurality of plateaus of the non-linear characteristic.
